# DEMANDE DE BREVET EUROPEEN

(11) **EP 4 780 171 A1**
(43) Date de publication de la demande: **22.07.2026**
(21) Numéro de dépôt: 26151850.0
(22) Date de dépôt: 14.01.2026
(51) Int. Cl.: H10F 71/00, H10F 10/166, H02S 40/10

(54) **REGENERATION DE PERFORMANCES DE MODULES PV DEGRADES PAR L' HUMIDITE**

(30) Priorité: 16.01.2025 FR 2500466
(71) Demandeur: Commissariat à l'Energie Atomique et aux Energies Alternatives, 75015 Paris (FR); université Clermont Auvergne, 63000 Clermont Ferrand (FR); Centre National de la Recherche Scientifique, 75016 Paris (FR)
(72) Inventeur: COUDERC, Romain, 38054 GRENOBLE Cedex 01 (FR); LAJOIE, Hugo, 73000 CHAMBERY (FR)
(74) Mandataire: Santarelli

(57) **Abrégé**

Procédé de traitement d'un module photovoltaïque (M) soumis à un environnement humide ou ayant été soumis à un milieu humide, le module étant doté d'au moins une couche de protection (10) en verre contenant du sodium, le procédé comprenant au moins l'étape suivante : exposer le module photovoltaïque à un rayonnement infrarouge et de préférence dans le proche infra-rouge, au moyen d'une source (40) de rayonnement infrarouge mise en mouvement de sorte à exposer une face dite principale du module selon une irradiance donnée et pendant une durée d'exposition déterminée et afin d'irradier des cellules photovoltaïques (C₁,..., C₂₄) de ce module.

## Description

### DOMAINE TECHNIQUE ET ART ANTERIEUR

La présente invention se rapporte au domaine des procédés et systèmes de traitement de module photovoltaïque pour restaurer au moins partiellement leurs performances lorsqu'ils ont été soumis à un milieu humide.

Les modules photovoltaïques sont sensibles à la chaleur et à l'humidité et ce, tout particulièrement lorsqu'ils sont munis de couche(s) de protection en verre contenant du sodium, tel que par exemple le verre sodocalcique.

En effet, l'humidité ambiante est susceptible de provoquer une lixiviation du sodium qui peut entrainer une migration d'ions sodium jusqu'aux cellules et dégrader fortement leurs performances.

Pour réduire les dégradations d'un module photovoltaïque liées à l'humidité, le document US20110094781 propose d'utiliser une couche permettant d'empêcher la diffusion de sodium provenant du verre vers les cellules.

Pour empêcher les dégradations d'un module photovoltaïque liées à l'humidité, le document US2014/158201 propose quant à lui de réaliser une protection avec du verre sans sodium.

De telles solutions nécessitent la mise en place d'équipements coûteux supplémentaires dans une chaîne de production, et peuvent s'avérer difficilement industrialisables.

### EXPOSE DE L'INVENTION

C'est par conséquent un but de la présente invention d'offrir une nouvelle solution pour permettre à des modules photovoltaïques dotés d'au moins une couche de protection en verre contenant du sodium et soumis à un milieu humide de conserver leurs performances électriques.

Selon un mode de réalisation, la présente invention prévoit un procédé de traitement d'un module photovoltaïque exposé ou ayant été exposé à un environnement humide, le module étant doté d'au moins une couche de protection en verre contenant du sodium, le procédé comprenant au moins l'étape suivante : soumettre le module photovoltaïque à un rayonnement infrarouge et de préférence dans le proche infra-rouge, au moyen d'une source de rayonnement infrarouge mise en mouvement pour irradier une face principale de ce module selon une irradiance donnée et pendant une durée d'exposition déterminée à ce rayonnement, afin d'irradier des cellules photovoltaïques de ce module.

Un tel procédé permet d'améliorer la durée de vies de modules photovoltaïques traités, mais aussi le maintien de leurs performances à des hauts rendements de conversion en cours d'utilisation.

Ainsi, avec un tel procédé on peut régénérer des modules photovoltaïques d'une installation en augmentant de manière importante le rendement des modules en cours d'utilisation même lorsqu'ils sont exposés ou ont été exposés à un environnement humide.

Selon un mode de réalisation avantageux, la mise en mouvement de la source de rayonnement est effectuée de sorte à exposer uniquement des cellules situées en regard d'une région périphérique de la face principale du module et sans exposer des cellules situées en regard d'une région centrale de ladite face principale.

De préférence, l'exposition des cellules est nocturne et/ou sans exposer concomitamment le module à une lumière solaire.

Selon une mise en œuvre avantageuse du procédé, l'irradiance donnée est comprise entre 0.5 kW/m² et 30 kW/m², avantageusement entre 1 kW/m² et 15 kW/m², de préférence entre 3 et 5 kW/m².

La durée d'exposition peut être prévue supérieure à 1 heure et de préférence comprise entre 2h et 10h ou la durée d'une nuit.

Avantageusement, durant l'exposition au rayonnement IR, le module est maintenu à une température inférieure à 90°C, typiquement entre 25°C et 90°C.

Selon une possibilité de mise en œuvre, le procédé peut comprendre en outre une étape de nettoyage de la face principale du module, avantageusement concomitante à l'exposition au rayonnement infrarouge.

Avantageusement, les cellules photovoltaïques du module traité sont des cellules à hétérojonction.

Selon un autre aspect, l'invention concerne également un système de traitement de module photovoltaïque pour la mise en œuvre d'un procédé tel que défini précédemment.

Un tel système comprend typiquement :
- une source d'émission de rayonnement IR,
- des moyens de mise en mouvement de ladite source de rayonnement IR,
- une unité de commande configurée pour contrôler ladite source d'émission de rayonnement IR en vue d'émettre lesdits rayonnements électromagnétiques pendant une durée d'exposition déterminée, à une irradiance donnée à destination d'au moins une partie d'une surface à traiter d'un module photovoltaïque et pour contrôler les moyens de mise en mouvement et déplacer ladite source d'émission.

### BREVE DESCRIPTION DES DESSINS

La présente invention sera mieux comprise sur la base de la description qui va suivre et des dessins en annexe sur lesquels:
La figure 1 est une vue d'un module photovoltaïque (PV).
La figure 2A sert à illustrer un système de traitement de module PV pour appliquer au module un rayonnement IR selon une durée et une irradiance, prévues pour permettre de restaurer au moins partiellement des performances électriques de module qui ont été dégradées suite à une exposition de ce module à un milieu humide.
La figure 2B sert à illustrer une trajectoire particulière du système de traitement pour lui permettre de n'exposer que des cellules agencées en bordure du module PV.
La figure 3 sert à illustrer une comparaison de résultats expérimentaux entre des traitements d'irradiations de modules PV effectués par des sources émettant dans des gammes de longueurs d'ondes différentes.
La figure 4 sert à illustrer une comparaison de résultats expérimentaux entre des traitements d'irradiations effectués sur des modules PV par des LED IR et des traitements réalisés par des LED émettant dans une gamme de longueur d'onde distincte.
La figure 5 sert à illustrer des résultats expérimentaux de traitements d'irradiations effectués sur des modules PV dont les couches de protection avant et arrière sont en verre.

Des parties identiques, similaires ou équivalentes des différentes figures portent les mêmes références numériques de façon à faciliter le passage d'une figure à l'autre. Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

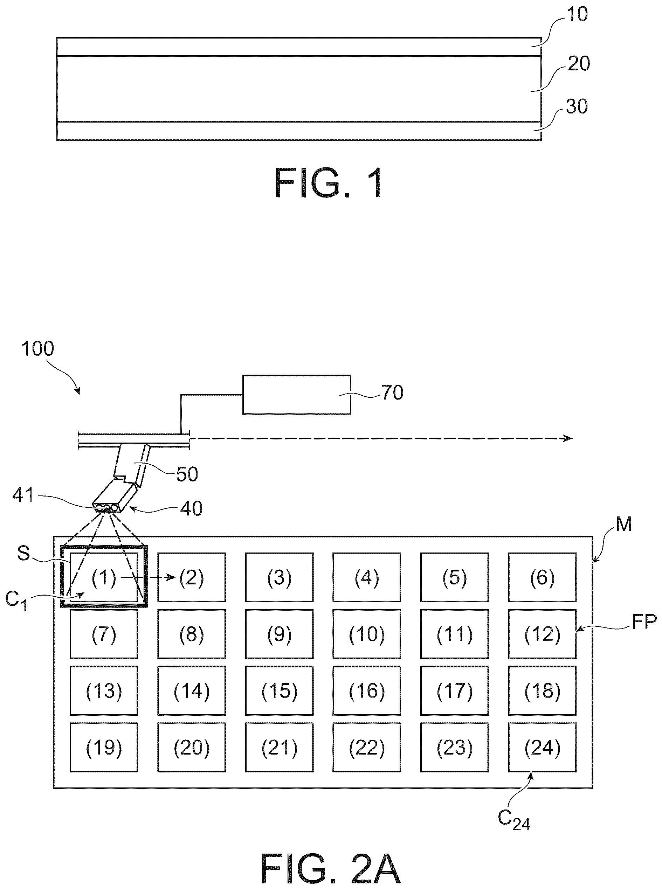

Un traitement, selon l'invention, pour restaurer au moins partiellement l'efficacité de cellules photovoltaïques d'un module photovoltaïque lorsqu'il a été exposé à un environnement humide peut s'appliquer à un module photovoltaïque conventionnel tel que représenté de manière schématique sur la figure 1.

Le module M comprend un ensemble 20 de cellules solaires encapsulées entre des couches de protection 10, 30.

Une couche 10 de protection dite « avant », à base de verre, recouvre le module M. Cette couche 10 de protection avant forme une surface externe plane du module destinée à être exposée au rayonnement solaire. Cette couche 10 de protection avant permet de protéger les cellules solaires des chocs mécaniques et des intempéries tout en permettant un passage optimal de la lumière. Le verre de la couche de protection frontale 10 contient typiquement du sodium et peut être par exemple un verre sodocalcique. A titre d'exemple particulier, la couche 10 de protection peut être sous forme d'une plaque de verre de type GMB SINA fabriqué par la société Interfloat.

Suite à une exposition de ce module à un milieu humide, le sodium présent dans le substrat en verre est susceptible de se diffuser dans des cellules de l'ensemble 20 et de dégrader les performances du module.

On estime en particulier une exposition significative comme une durée d'exposition à un taux d'humidité d'au moins 40%, pendant une durée d'au moins 1 an, et typiquement entre 1 et 10 ans.

Le module photovoltaïque est également pourvu d'une couche 30 de protection dite « arrière ». Cette couche 30 de protection arrière forme une barrière notamment contre l'humidité et offre une isolation électrique. La couche 30 de protection arrière peut être en matériau polymère, par exemple du polyfluorure de vinyle (PVF). En variante, la couche de protection 30 peut être également en verre, en particulier en verre contenant du sodium tel qu'un verre sodocalcique. Dans ce cas, à titre d'exemple particulier, la couche 30 de protection peut être sous forme d'une plaque de verre de type GMB SINA fabriqué par la société Interfloat.

L'ensemble 20 de cellules se présente sous forme d'une couche intermédiaire, intercalée entre la couche 10 de protection avant et la couche 30 de protection arrière. La couche intermédiaire comporte les cellules photovoltaïques, une connectique électrique et une enveloppe d'encapsulation arrangée autour des cellules photovoltaïques.

La connectique peut être avantageusement pourvue d'adhésif conducteur électrique, ou de ruban conducteur pour relier électriquement les cellules entre elles.

L'enveloppe d'encapsulation peut être à base d'un matériau polymère, tel que par exemple l'EVA (éthylène-acétate de vinyle), ou un polymère thermoplastique TPO (pour « Thermoplastic Polyolefin »).

Les cellules photovoltaïques peuvent être en particulier des cellules à hétérojonction de silicium, particulièrement sensibles à une contamination au sodium.

Selon un mode de réalisation particulier, le module photovoltaïque M peut être formé d'un ensemble de demi-cellules interconnectées.

Un cadre (ici non représenté), par exemple en aluminium, résistant à la corrosion, peut être prévu autour d'un tel assemblage pour permettre de garantir une rigidité structurelle.

Sur la figure 2A, un mode de réalisation d'un système 100 de traitement pour permettre de régénérer un module photovoltaïque ayant été exposé à un milieu humide est représenté.

Ce système 100 de traitement est prévu pour restaurer au moins partiellement l'efficacité de cellules photovoltaïques C₁,..., C₂₄ d'un module M, tel que décrit précédemment lorsque ce module M est exposé ou a été exposé à un environnement humide, ce qui se traduit généralement par une diffusion intempestive d'ions sodium dans des cellules. Des méthodes telles que décrites dans le document « Potential-free sodium-induced degradation of silicon heterojunction solar cells » de Xiaodong Li et al., tiré de la revue Progress in Photovoltaics: Research and Applications, avril 2023 permettent de détecter le sodium et d'analyser sa migration. Parmi ces méthodes on compte notamment, la spectrométrie de masse à temps de vol (ToF-SIMS), la microscopie électronique à balayage (SEM) et spectroscopie à dispersion d'énergie (EDX), la spectroscopie infrarouge à transformée de Fourier (FTIR), l'imagerie photoluminescente (PL).

Le système 100 de traitement comprend une source 40 émettrice de rayonnement électromagnétique, en particulier fonctionnant dans l'infra-rouge (IR), et avantageusement dans le proche infrarouge, en particulier dans une gamme de longueur d'ondes comprise entre 800 nm et 1200 nm. La source 40 peut être pourvue d'une ou plusieurs diodes électroluminescentes (LED) 41, typiquement d'une pluralité de diodes électroluminescentes agencées en une ou plusieurs rangées et intégrées à une structure de support 50. La structure de support 50 peut être par exemple sous forme d'un bras articulé et/ou robotisé.

La source d'émission 40 forme une zone d'éclairement correspondant typiquement au moins à toute la zone délimitée par les diodes électroluminescentes 41 de la source d'émission. Lorsque le support 50 du système est positionné en regard de la surface à traiter, les diodes électroluminescentes 41 de la source sont positionnées de manière à pouvoir exposer une surface dite « de traitement » d'une face dite « face principale » du module. La face principale FP du module correspond à une face exposée d'une des couches de protection du module, typiquement la couche de protection avant. La surface de traitement peut correspondre au dimensions d'au moins une portion de cellule solaire. Dans l'exemple de réalisation cette surface est supérieure à celle d'une cellule solaire C₁.

Le rayonnement est appliqué de sorte à exposer une cellule ou plusieurs cellules pendant une durée de traitement également appelée « durée d'exposition », déterminée, qui peut varier en fonction de l'irradiance (i.e. de la densité surfacique de puissance lumineuse) et de la longueur d'onde du rayonnement émis. La dose d'irradiance cumulée lors du traitement est de préférence d'au moins 1 kWh/m², typiquement comprise entre 15 kWh/m² et 60 kWh/m².

Avantageusement, le rayonnement est appliqué de sorte à exposer une cellule à la fois (i.e. cellule par cellule), voire sur une partie d'une cellule à la fois.

Pour cela, le rayonnement électromagnétique peut être émis à une irradiance comprise par exemple entre 0,5 kW/m² et 30 kW/m² avantageusement entre 3 kW/m² et 5 kW/m² et pendant une durée comprise par exemple entre 2h et 10h.

On privilégie de préférence une irradiation de longue durée, en particulier d'au moins 1 heure, de préférence d'au moins 2 heures, en particulier entre 2 h et 5h. Une irradiation de longue durée avec une irradiance limitée permet de limiter les contraintes thermiques imposées au module.

Pendant l'exposition du module M au rayonnement issu de la source 40, la température du module photovoltaïque M est de préférence maintenue à une température en particulier inférieure à 90°C, par exemple comprise entre 25°C et 90°C. Pour cela, des moyens de refroidissement, utilisant un fluide caloporteur ou par exemple de l'eau, pour réguler la température en surface du module exposé, peuvent être mis en œuvre. On s'assure ainsi de ne pas risquer d'endommager le module photovoltaïque M.

On privilégie également une exposition du module photovoltaïque M à la source d'émission 40 durant la nuit et/ou sans exposer concomitamment le module photovoltaïque M à la lumière solaire. De cette manière, on optimise la régénération du module.

La source 40 et en particulier la dose d'irradiance ou l'irradiance, sa trajectoire, peuvent être contrôlées au moyen d'une unité de commande 70 typiquement dotée d'un ou plusieurs éléments parmi : un processeur, un contrôleur de position et/ou de vitesse et/ou de couple et/ou de trajectoire, un contrôleur PLC (Programmable Logic Controller), une interface Homme-Machine (IHM).

L'unité de commande 70 contrôle en particulier des moyens de mise en mouvement du support 50 comprenant par exemple au moins un élément parmi : un moteur électrique, un actionneur hydraulique ou pneumatique, un système muni de câbles et de poulies ou de courroies.

Pour permettre notamment de limiter la durée de traitement d'un module photovoltaïque tout en optimisant la restauration de ses performances, le système de traitement 100 peut être configuré pour n'exposer qu'une partie no de la face principale FP du module M exposée au rayonnement de la source 40. En effet, dans la mesure où ce sont typiquement essentiellement les cellules périphériques qui subissent les effets de l'humidité et la diffusion de sodium provenant de la ou les couches de protection en verre, on peut prévoir avantageusement de ne traiter que ces cellules périphériques.

Ainsi, la mise en mouvement du support 50 ou bras 50 peut être effectuée de manière à exposer uniquement des cellules situées en regard d'une région périphérique de face principale FP du module M sans exposer d'autres cellules situées en regard d'une région centrale de cette même face, la région périphérique étant une région de la face principale située autour de la région centrale.

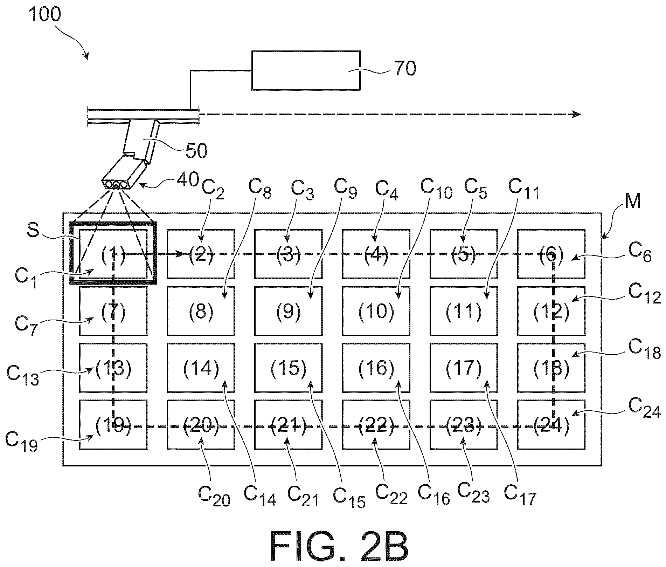

Dans l'exemple de réalisation illustré sur la figure 2B, on peut prévoir ainsi, par exemple, de soumettre au rayonnement IR régénérant, les cellules C₁, C₂, C₃, C₄, C₅, C₆, C₁₂, C₁₈, C₂₄, C₂₃, C₂₂, C₂₄, C₂₁, C₂₀, C₁₉, C₁₃, C₇ situées en bordure du module M et sur une trajectoire Tr, et de ne pas exposer les cellules C₈, C₉, C₁₀, C₁₁, C₁₄, C₁₅, C₁₆, C₁₇ situées dans une région centrale du module M. On peut ensuite passer au traitement d'un autre module photovoltaïque.

Ainsi, dans un champ photovoltaïque ou une installation comportant un ou plusieurs autres modules à traiter, on effectue ensuite l'irradiation des autres modules, avantageusement en suivant les bordures ou la périphérie de la face principale de chacun des modules à traiter.

Avantageusement, on peut coupler le traitement d'irradiation d'un module M à une étape de nettoyage de la surface exposée, en particulier de la couche de protection avant. Le nettoyage, par exemple par brossage, peut être avantageusement effectué concomitamment à l'exposition. Pour cela, des moyens de nettoyage, tels qu'une brosse ou une structure munie d'un tissu, solidaires du support 50 en déplacement peuvent être prévus. Cela peut permettre d'effectuer un nettoyage de la surface à exposer au rayonnement IR au fur et à mesure du déplacement du support 50.

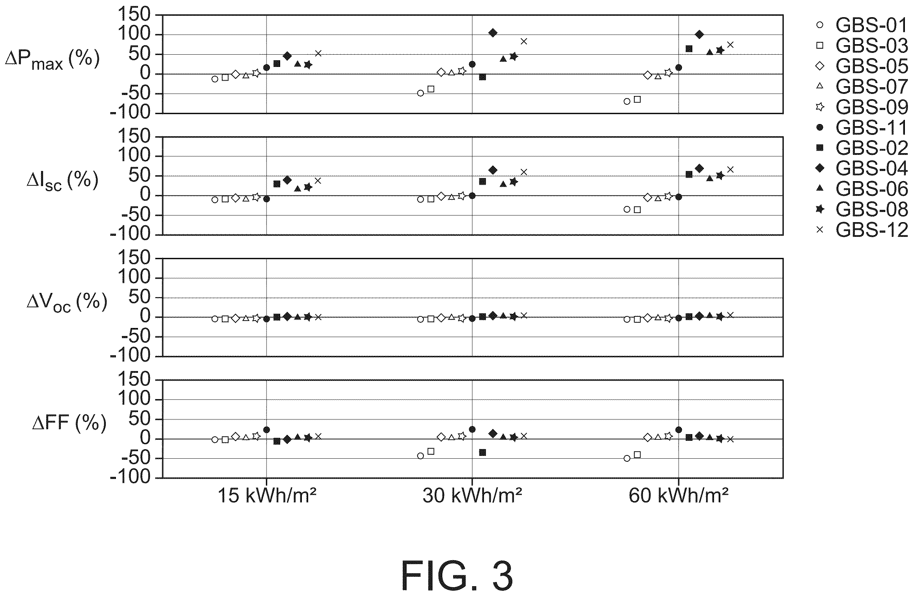

On se réfère à présent à la figure 3 qui sert à illustrer des résultats de traitement d'éclairement sur différents modules PV ayant été exposés à un environnement humide, afin de restaurer au moins partiellement leurs performances électriques. Les modules testés sont ici munis d'une couche de protection avant en verre et d'une couche de protection arrière en polymère et sont formés de cellules à hétérojonctions. Ces modules ont été soumis à un environnement chaud et humide DH (« damp heat » selon la terminologie anglosaxonne) de l'ordre de 85 % RH et à une température de l'ordre de 85°C pendant une durée comprise entre 750 h et 1000 h de DH suivant la norme IEC 61215. Certains modules (points GBS-02, GBS-04, GBS-06, GBS-08, GBS-12 sur la figure 3) ont été exposés à un rayonnement selon un spectre large de longueurs d'onde comprises entre 300 nm et 1200 nm, à une dose de 60 kWh/m² et ont été maintenus à une température de l'ordre de 60 °C. D'autres modules (points GBS-01, GBS-03, GBS-05, GBS-07, GBS-09, GBS-11 sur la figure 3) ont été exposés à la même dose mais à un rayonnement selon un spectre plus étroit de longueurs d'onde comprises entre 280 nm et 700 nm, qui exclue par conséquent l'infra-rouge. Les résultats sont ici exprimés en pourcentage et en termes de variation par rapport à des mesures effectuées sur chaque module avant traitement et après avoir subi lesdites conditions d'humidité.

On constate qu'avec une exposition à un rayonnement de spectre le plus large, la régénération peut atteindre 100% d'augmentation de puissance maximale (ΔPmax) par rapport à son état après soumission à l'environnement chaud et humide DH avant le traitement. En revanche, l'exposition avec le spectre qui exclue l'IR, on ne constate pas le même phénomène. Certains modules (points GBS_01 et GBS_03) présentent même des dégradations supplémentaires.

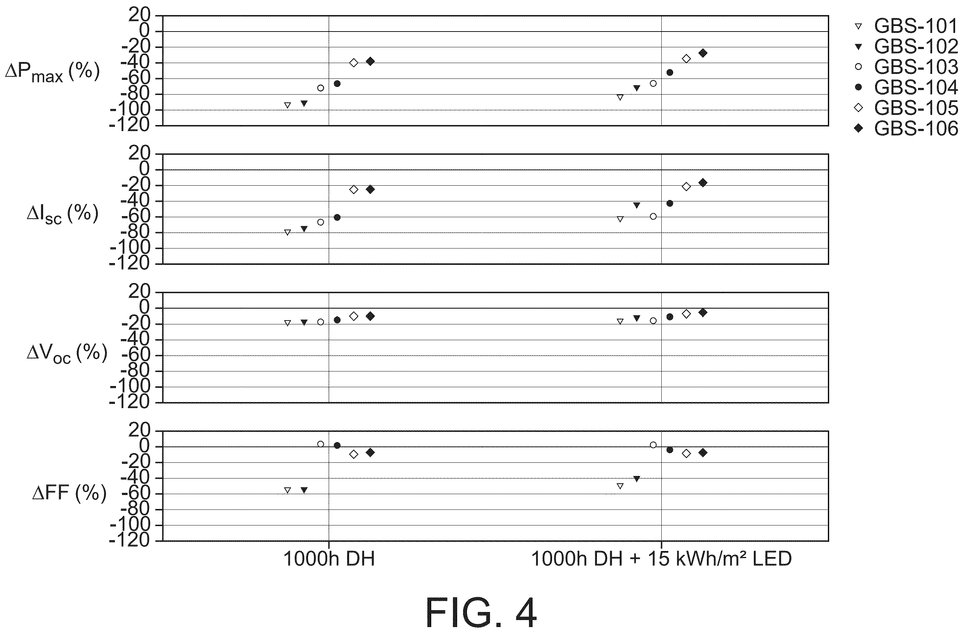

Ces résultats, ainsi que ceux donnés sur la figure 4, confirment l'avantage de prévoir une source de rayonnement électromagnétique émettant dans le spectre IR. La figure 4 montre des résultats de tests d'irradiation effectués sur des modules PV ayant subi les mêmes conditions d'humidité et que l'on expose ensuite un rayonnement provenant d'une source munie de LEDs émettant à la longueur d'onde 455 nm (points GBS_101, GBS_103, GBS_105) en comparaison avec des LEDs dans le proche infrarouge à une longueur d'onde de 940 nm (points GBS_102, GBS_104, GBS_106), pour une dose d'irradiation de 15 kWh/m² après 1000 h de DH. Le phénomène de régénération est, là encore, plus efficace avec les LEDs émettant dans le proche infrarouge. Ainsi , l'irradiation par IR permet d'améliorer la puissance maximale Pmax, le courant de court-circuit Isc, la tension en circuit ouvert Voc, le facteur de forme FF (« Fill Factor »).

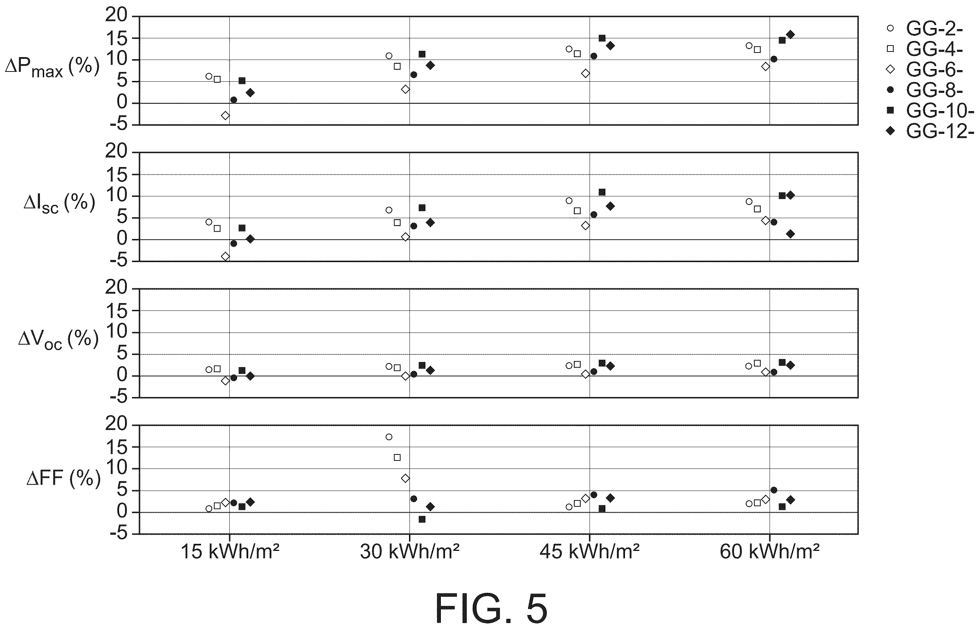

La figure 5 donne, quant à elle, des résultats d'un traitement d'éclairement mis en œuvre sur d'autres modules photovoltaïques exposés aux mêmes conditions d'humidité que celles de la figure 3, mais cette fois munis d'une couche de protection avant en verre et d'une couche de protection arrière également en verre.

L'exposition de ces modules est effectuée sous un éclairement de type AM1.5G qui correspond à un standard pour représenter les conditions moyennes d'ensoleillement au niveau du sol. Une régénération des performances du module est ici également observée en ce qui concerne la puissance maximale Pmax, le courant de court-circuit Isc, la tension en circuit ouvert Voc, le facteur de forme FF.

Un traitement de régénération de modules PV par exposition à un rayonnement électromagnétique tel que décrit précédemment peut être aussi bien mis en œuvre sur des modules légèrement dégradés par l'humidité et ayant subi par exemple une baisse de puissance maximale de l'ordre de 30% qu'avec des modules fortement dégradés par l'humidité et ayant subi une baisse de puissance maximale par exemple de l'ordre de 70 %.

De préférence, pour un module PV mis en service et en activité, un traitement de régénération par irradiation IR tel que décrit précédemment est réitéré périodiquement. Il s'applique par exemple dans une centrale photovoltaïque en cours d'activité, comportant une pluralité de modules photovoltaïques tels que des modules formés avec des cellules photovoltaïques à hétérojonction de silicium. Par exemple, tous les 1 à 30 jours d'utilisation, selon une durée qui dépend des conditions climatiques du milieu dans lequel le module est disposé, on effectue à nouveau un traitement d'irradiation IR selon des conditions telles que décrites précédemment.

## Revendications

1. Procédé de traitement d'au moins un module photovoltaïque (M) soumis à un environnement humide ou ayant été soumis à un milieu humide, le module étant doté d'au moins une couche de protection (10) en verre contenant du sodium, le procédé comprenant au moins l'étape suivante : exposer le module photovoltaïque à un rayonnement infrarouge et de préférence dans le proche infra-rouge, au moyen d'une source (40) de rayonnement infrarouge mise en mouvement de sorte à exposer une face dite principale du module selon une irradiance donnée, en particulier comprise entre 0,5 kW/m² et 30 kW/m² et pendant une durée d'exposition déterminée, typiquement d'au moins une heure afin d'irradier des cellules photovoltaïques (C₁,..., C₂₄) de ce module.

2. Procédé de traitement selon l'une des revendications précédentes, dans lequel la mise en mouvement de la source de rayonnement est effectuée de sorte à exposer uniquement des cellules situées en regard d'une région périphérique d'une face principale (FP) du module (M) et sans exposer des cellules situées en regard d'une région centrale de ladite face.

3. Procédé de traitement selon l'une des revendications précédentes, dans lequel ladite exposition est réalisée durant la nuit et/ou sans exposer concomitamment le module à une lumière solaire.

4. Procédé selon l'une des revendications précédentes dans lequel les cellules photovoltaïques (C₁,..., C₂₄) sont des cellules à hétérojonction.

5. Procédé selon l'une des revendications précédentes, dans lequel le traitement comporte au moins une étape de nettoyage de ladite face principale (FP) du module, avantageusement concomitante à ladite exposition au rayonnement infrarouge.

6. Procédé selon l'une des revendications précédentes, dans lequel l'irradiance donnée est comprise entre 1 kW/m² et 15 kW/m², de préférence entre 3 et 5 kW/m².

7. Procédé selon l'une des revendications précédentes, dans lequel la durée d'exposition déterminée est comprise entre 2 et 10 heures.

8. Procédé selon l'une des revendications 6 ou 7, dans lequel, durant l'exposition, le module (M) est maintenu à une température inférieure à 90°C, typiquement entre 25°C et 90°C.
